**Europäisches Patentamt**

**European Patent Office**

**Office européen des brevets**

(19)

(11) **EP 1 182 784 A2**

(12) **EUROPÄISCHE PATENTANMELDUNG**

(43) Veröffentlichungstag:
27.02.2002 Patentblatt 2002/09

(51) Int Cl.⁷: **H03M 1/36**, H01C 13/00

(21) Anmeldenummer: 01119466.9

(22) Anmeldetag: **13.08.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **23.08.2000 DE 10041437**

(71) Anmelder: **Infineon Technologies AG**
**81669 München (DE)**

(72) Erfinder:
• **Hoenlein, Wolfgang, Dr.**
**82008 Unterhaching (DE)**
• **Thewes, Roland, Dr.**
**82194 Groebenzell (DE)**

(74) Vertreter: **Viering, Jentschura & Partner**
**Postfach 22 14 43**
**80504 München (DE)**

(54) **Widerstandskaskade zum Bilden elektrischer Referenzgrössen und Analog-/Digital-Wandler**

(57) Eine Widerstandskaskade weist eine Vielzahl von elektrischen Widerständen auf, die in Serie geschaltet sind und jeder elektrische Widerstand weist mindestens eine einwandige Kohlenstoff-Nanoröhre auf.

# FIG 1

**Beschreibung**

Die Erfindung betrifft eine Widerstandkaskade zum Bilden elektrischer Referenzgrößen sowie einen Analog-/Digital-Wandler.

Eine solche Widerstandskaskade und ein solcher Analog/Digital-Wandler sind aus [1] bekannt.

In verschiedenen schaltungstechnischen Anwendungen, insbesondere in Analogschaltungen, ist es erforderlich, elektrische Referenzgrößen in möglichst exakt gestufter Form zur Verfügung zu stellen.

So ist es beispielsweise bekannt, eine Widerstandskaskade mit N gleichen elektrischen Widerständen R und einer Referenzspannung $V_{ref}$ derart zu betreiben, dass an den Abgriffen zwischen jeweils zwei elektrischen Widerständen die elektrischen Spannungen der Serienschaltung von elektrischen Widerständen gemäß folgender Vorschrift zur Verfügung gestellt werden:

$$V(n) = \frac{v_{ref} \cdot n}{N}, \qquad \text{mit } 1 \leq n \leq N. \qquad (1)$$

Eine derartige Widerstandskaskade wird beispielsweise in einem sogenannten Flash-Analog-/Digital-Wandler eingesetzt.

Das analoge Eingangssignal wird in diesem Fall mit Hilfe von Komparatoren mit den verschiedenen Spannungen gemäß Vorschrift (1) verglichen.

Dabei ergibt sich an den Ausgängen der Komparatoren, an deren Eingängen das analoge Eingangssignal größer als der Wert V(n) ist, ein logisches High-Signal, an den Ausgängen aller anderen Komparatoren jedoch ein logisches Low-Signal.

Die Ausgangssignale der Komparatoren werden in einem an die Komparatoren angeschlossenen Logikschaltkreis, der im weiteren als Auswertelogik bezeichnet wird, logisch miteinander verknüpft und in ein logisches Ausgangssignal in der jeweils gewünschten logischen Darstellung konvertiert.

Die maximal erzielbare Genauigkeit eines solchen Analog/Digital-Wandlers hängt erheblich von der Genauigkeit und den Parametervariationen der eingesetzten Komponenten, insbesondere der eingesetzten Widerstände in der Widerstandskaskade ab.

Die Referenzspannung $V_{ref}$ kann über sogenannte Bandgap-Schaltungen bereitgestellt werden. Diese erzielen in den meisten Fällen eine derart hohe Genauigkeit, dass Variationen der Referenzspannung $V_{ref}$ nur eine untergeordnete Bedeutung bezüglich der Genauigkeit des gesamten Analog-/Digital-Wandlers spielen.

Ferner existieren Schaltungsvarianten und Anwendungsvarianten, bei denen diese Referenzspannung $V_{ref}$ extern bereitgestellt bzw. justiert wird.

Eine kritische Größe für die Komparatoren ist jedoch deren Eingangs-Offset-Spannung.

Insbesondere bei einem CMOS-Komparator ist diese im wesentlichen durch das Schwellenspannungs-Mismatch der Eingangstransistoren des Komparators bestimmt.

Das Schwellenspannungs-Mismatch kann durch Vergrößerung der Fläche dieser Transistoren, gemäß den in [1] und [2] beschriebenen Gesetzmäßigkeiten vermindert werden, wobei diese Maßnahme aufgrund der zur Verfügung stehenden Fläche für die einzelnen elektrischen Bauelemente in dem Komparator wie auch aus anderen Gründen nur bedingt tauglich ist.

Eine weitere Möglichkeit besteht darin, sogenannte Auto-Zeroing-Schaltungen einzusetzen. Bei einer solchen Auto-Zeroing-Schaltung wird der Eingangs-Offset einer gegebenen offset-behafteten Schaltung in zeitlich periodischen Abständen gemessen und es wird eine Zwischenspeicherung dieses Wertes angelegt und bei aktivem Betrieb der eigentlichen offset-behafteten Schaltung werden von dem Differenzsignal diese zwischengespeicherten Werte wieder abgezogen, um die Eingangs-Offset-Spannung zu kompensieren.

Eine weitere bedeutende Ursache für die Ungenauigkeit eines Analog-/Digital-Wandlers liegt ferner in lokalen und langreichweitigen Parametervariationen der Widerstandskaskade.

Sogenannte lokale Variationen, die auch als Nahfeld-Mismatch bezeichnet werden, entstehen durch statistische Prozesse bei der Herstellung der elektrischen Widerstände der Widerstandskaskade und sind aufgrund grundsätzlicher physikalischer Grundgesetze nicht vermeidbar.

Bei elektrischen Widerständen aus polykristallinem Silizium variiert der Wert des elektrischen Widerstands beispielsweise proportional zum Kehrwert der Wurzel aus der mittleren Anzahl der Körner des polykristallinem Siliziums eines elektrischen Widerstands gegebener Fläche, wie in [3] beschrieben.

Auch in diesem Fall vermindert eine Vergrößerung der Fläche die Parametervariation, führt aber zwangsläufig zu einem erhöhten Flächenbedarf auf einem Chip, das heißt zu einer erheblichen räumlichen Ausdehnung der sich ergebenen Widerstandskaskade.

Da eine Widerstandskaskade jedoch grundsätzlich nicht auf engem Raum konzentriert sein kann, führen langreichweitige Effekte wie beispielsweise die Linienbreitenschwankungen, zu Gradienten in den Werten der elektrischen Widerstände, wie in [4] beschrieben.

Während also eine Flächenvergrößerung zu einer Verbesserung des Matching-Verhaltens benachbarter elektronischer Bauelemente führt, können durch diese Maßnahme beeinflusst langreichweitige Gradienten im Rahmen des Mismatch durchaus im negativen Sinne zunehmen.

Weiterhin sind Parametervariationen in den elektrischen Widerständen auch

- auf die Ungenauigkeit bei der Dotierung der einzelnen Bauelemente,

- auf die inhomogene Verteilung der elektrischen Ladungsträger, die insbesondere zurückzuführen ist auf Defekte in den Kristallgittern der verwendeten Materialien, sowie
- auf Ungenauigkeiten im Rahmen der Herstellungsprozesse, insbesondere bei der Photolithographie,

zurückzuführen.

Weiterhin sind Grundlagen über Kohlenstoff-Nanoröhren aus [5] bekannt.

Weiterhin ist ein Herstellungsverfahren für Kohlenstoff-Nanoröhren aus [6] bekannt.

Ferner ist aus [7] bekannt, dass der elektrische Widerstand einer einwandigen Kohlenstoff-Nanoröhre gegeben ist durch den sogenannten Klitzing-Widerstand, der ungefähr 26,5 k'Ω beträgt und unabhängig ist von der Länge und dem Durchmesser der Kohlenstoff-Nanoröhre.

In [8] ist ein Verfahren beschrieben, bei dem Kohlenstoff-Nanoröhren mittels selbstjustierten Abscheidens zwischen zwei Kontaktflächen abgeschieden werden.

In [9] ist ein Bezugsspannungsgenerator für einen A/D-Wandler oder einen D/A-Wandler beschrieben, bei dem in einem Spannungsabgleichschaltkreis, implementiert als Widerstandskaskade, Trenneinrichtungen zwischen einzelnen Widerständen vorgesehen sind.

Weiterhin ist aus [10] eine weitere aus elektrischen ohmschen Widerständen und Transistoren aufgebaute Widerstandskette bekannt.

Der Erfindung liegt das Problem zugrunde, eine Widerstandskaskade sowie einen Analog-/Digital-Wandler anzugeben, mit denen insbesondere die Parametervariationen der elektrischen Widerstände reduziert werden.

Das Problem wird durch die Widerstandskaskade sowie durch den Analog-/Digital-Wandler mit den Merkmalen gemäß den unabhängigen Patentansprüchen gelöst.

Eine Widerstandskaskade zum Bilden elektrischen Referenzgrößen aus einer Referenzspannung, die vorzugsweise von einer Referenzspannungsquelle bereitgestellt wird, weist eine Mehrzahl elektrischer Widerstände auf, die in Serie miteinander gekoppelt sind. Jeder elektrische Widerstand wird durch mindestens eine Kohlenstoff-Nanoröhre gebildet.

Eine solche Kohlenstoff-Nanoröhre weist, wie oben beschrieben, einen von der Länge und dem Durchmesser im wesentlichen unabhängigen Wert ihres elektrischen Widerstands von 26,5 k'Ω auf.

Bei Vernachlässigung der Kontaktwiderstände, die eine elektrische Kopplung zwischen den einzelnen Nanoröhren ermöglichen, ist somit unabhängig von der Länge und dem Durchmesser der einwandigen Kohlenstoff-Nanoröhren eine Widerstandskaskade angegeben, die eine sehr genaue, von den Herstellungsbedingungen im wesentlichen unabhängige und sehr robuste und genaue Widerstandskaskade mit sehr genau gleichen einzelnen elektrischen Widerständen, den Kohlenstoff-Nanoröhren, zur Verfügung stellt.

Um einen elektrischen Widerstand mit einem Wert bereitzustellen, der sich von 26,5 k'Ω unterscheidet, kann, um diesen gewünschten Widerstandswert bereitzustellen, ein elektrischer Widerstand durch eine Parallelschaltung und/oder eine Serienschaltung mehrerer Nanoröhren, beispielsweise einwandiger Kohlenstoff-Nanoröhren gebildet werden.

Ein Analog-/Digital-Wandler weist eine Widerstandskaskade mit einer Mehrzahl von Kohlenstoff-Nanoröhren auf sowie eine der Anzahl elektrischer Widerstände entsprechende Anzahl von Komparatoren. Die Widerstandskaskade, d.h. insbesondere jeweils ein Abgriff jeweils zwischen zwei Widerständen der Widerstandskaskade, ist jeweils mit einem ersten Eingang eines Komparators gekoppelt, so dass abhängig von der Spannungsquelle, die die Referenzspannung zur Verfügung stellt, jeweils ein vorgegebener Bruchteil gemäß Vorschrift (1) an dem jeweiligen Abgriff zwischen den Kohlenstoff-Nanoröhren bereitgestellt wird und mit dem jeweiligen ersten Eingang des Komparators gekoppelt ist und somit dem jeweiligen Komparator angelegt wird.

An einem zweiten Eingang jeden Komparators ist das jeweilige analoge Signal, welches von dem Analog-/Digital-Wandler in ein digitales Signal umgewandelt werden soll, anlegbar.

Auf diese Weise wird ein Analog-/Digital-Wandler mit einer gegenüber dem Stand der Technik erheblich verbesserten Genauigkeit angegeben, die ferner hinsichtlich unterschiedlicher Herstellungsbedingungen sehr robust und störungsunanfällig ist.

Ein weiterer Vorteil der erfindungsgemäßen Widerstandskaskade und des erfindungsgemäßen Analog-/Digital-Wandlers ist darin zu sehen, das aufgrund der dreidimensionalen Struktur der Kohlenstoff-Nanoröhre nunmehr eine dreidimensionale Verdrahtung und Kopplung der einzelnen elektrischen Widerstände untereinander ermöglicht ist.

Gemäß einer Ausgestaltung der Erfindung ist es vorgesehen, dass die Ausgänge der Komparatoren mit einer Auswertelogik gekoppelt sind.

Ein Ausführungsbeispiel der Erfindung ist in den Figuren dargestellt und wird im weiteren näher erläutert.

Es zeigen:

Figur 1    einen elektrischen Widerstand mit einer Kohlenstoff-Nanoröhre gemäß einem Ausführungsbeispiel der Erfindung.

Figur 2    eine Widerstandskaskade gemäß einem Ausführungsbeispiel der Erfindung.

Figur 3    einen Analog-/Digital-Wandler gemäß einem Ausführungsbeispiel der Erfindung.

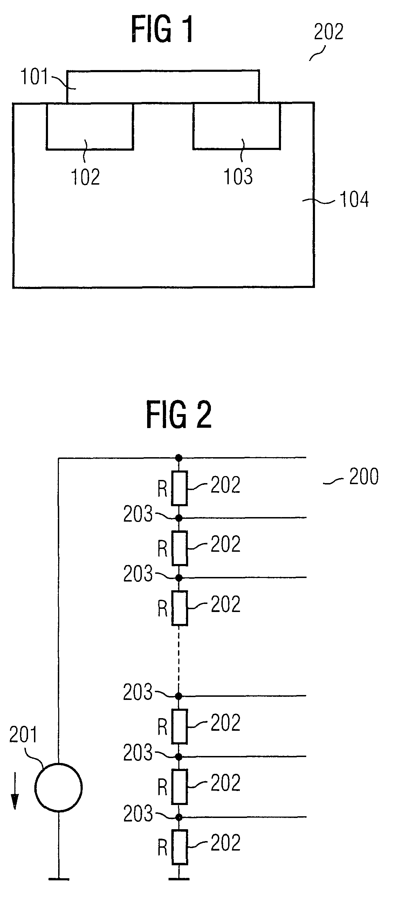

**Fig.2** zeigt eine Widerstandskaskade 200 mit einer Spannungsquelle 201, die eine Referenzspannung $V_{ref}$ bereitstellt.

Die Spannungsquelle 201 ist gekoppelt mit einer Vielzahl elektrischer Widerstände 202, die miteinander in Serie gekoppelt sind.

Die Anzahl der elektrischen Widerstände 202 ist grundsätzlich frei wählbar.

An Abgriffen 203 zwischen jeweils zwei elektrischen Widerständen 202 liegen abhängig von der Referenzspannung $V_{ref}$ jeweils folgende elektrische Spannungen V(n) an:

$$V(n) = \frac{v_{ref} \cdot n}{N} , \qquad \text{mit } 1 \leq n \leq N. \qquad (1)$$

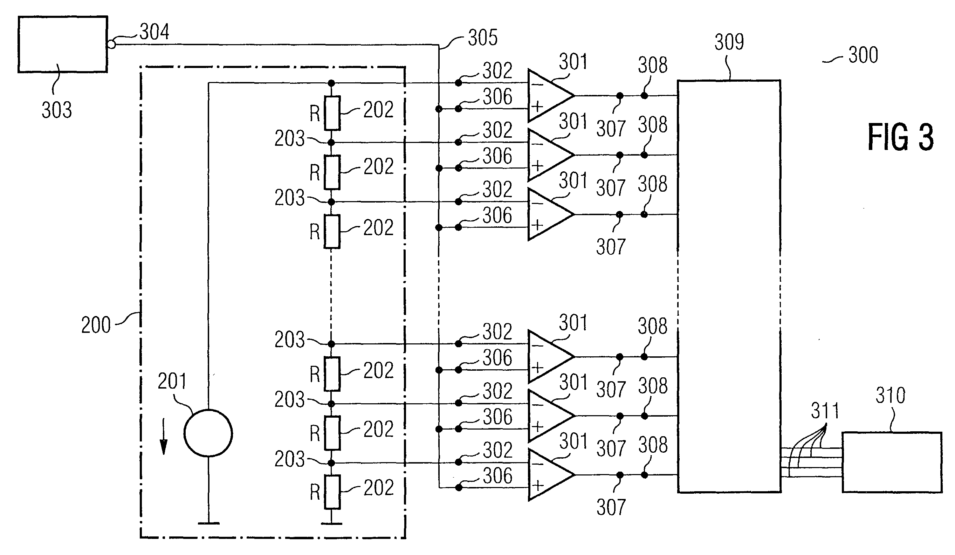

Die Widerstandskaskade 200 wird gemäß diesem Ausführungsbeispiel in einem Analog-/Digital-Wandler 300, wie in **Fig.3** dargestellt, eingesetzt.

Jeder Abgriff 203 der Widerstandskaskade 200 ist mit einem entsprechenden Komparator 301, insbesondere einem ersten Eingang 302 gemäß den Ausführungsbeispiel dem invertierenden Eingang des Komparators 301, angeschlossen.

Mit anderen Worten ausgedrückt bedeutet dies, dass eine entsprechend den elektrischen Widerständen 202 entsprechende Zahl Komparatoren 301 vorgesehen ist, an deren jeweils invertierenden Eingang 302 jeweils ein Abgriff 203 zwischen zwei elektrischen Widerständen 202 der Widerstandskaskade 200 angeschlossen ist.

Ein in ein digitales Ausgangssignal umzuwandelndes analoges Eingangssignal 303 ist an einem Eingang 304 des Analog/Digital-Wandlers 300 anlegbar.

Der Eingang 304 des Analog-/Digital-Wandlers 300 ist über eine Eingangsleitung 305 an jeweils einen zweiten Eingang 306 eines jeden Komparators 301 angeschlossen, gemäß diesem Ausführungsbeispiel an den nicht-invertierenden Eingang des jeweiligen Komparators 301.

Jeder Ausgang 307 eines Komparators 301 ist jeweils mit einem dafür vorgesehenen Eingang 308 einer Auswertelogik 309 gekoppelt, die gemäß einer vorgegebenen Abbildungsvorschrift das digitale Ausgangssignal 310, welches an einem oder mehreren Ausgängen 311 der Auswertelogik 309 bereitgestellt wird, erzeugt.

Jeder elektrische Widerstand 202 der Widerstandskaskade 200 wird gebildet durch eine oder mehrere einwandige Kohlenstoff-Nanoröhren.

Soll ein elektrischer Widerstand 202 der Widerstandskaskade 200 einen Wert von 26,5 k'Ω aufweisen, so wird jeweils eine einwandige Kohlenstoff-Nanoröhre für den elektrischen Widerstand 202 verwendet.

Soll jedoch ein anderer Widerstandswert für einen elektrischen Widerstand 202 realisiert werden, so wird eine Mehrzahl oder Vielzahl von Kohlenstoff-Nanoröhren in Serie oder parallel geschaltet, so dass sich aufgrund der Serienschaltung und/oder Parallelschaltung der gewünschte Wert des jeweiligen elektrischen Widerstands 202 ergibt.

Der elektrische Widerstand 202 gemäß dem Ausführungsbeispiel mit einer einwandigen Kohlenstoff-Nanoröhre ist in **Fig.1** dargestellt.

Der elektrische Widerstand 202 der Widerstandskaskade 200 wird gebildet durch eine einwandige Kohlenstoff-Nanoröhre 101, die an zwei elektrisch leitende Kontaktflächen 102, 103 elektrisch gekoppelt ist und mechanisch gebunden ist, wobei die Kohlenstoff-Nanoröhre 101 beispielsweise mittels selbstjustierten Abscheidung gemäß dem in [8] beschriebenen Verfahren zwischen den beiden Kontaktflächen 102, 103 abgeschieden wird.

Die Kontaktflächen 102, 103 sind in einem elektrisch isolierenden Substrat 104 eingebettet.

Die Kontaktflächen 102 ,103 können ganz oder teilweise aus Katalysatoren für das Abscheiden der einwandigen Kohlenstoff-Nanoröhren, wie in [6] beschrieben, ausgeführt sein, d.h. beispielsweise aus Platin, Eisen, Kobalt oder Nickel, und bilden die elektrischen Zuleitungen für die oben beschriebenen Komparatoren 301 des Analog-/Digital-Wandlers 300.

In diesem Dokument sind folgende Veröffentlichungen zitiert:

[1] M. Pelgrom et al., IEEE Journal of Solid-State-Circuits, S. 1075, 1989

[2] K. Lakshmikumar et al., IEEE Journal of Solid-State-Circuits, S. 1057, 1986

[3] R. Thewes et al., IDEM Technical Digest, S. 771 - 774, 1998

[4] U. Schaper, C. Linnenbank und R. Thewes, A Novel Approach for Precise Characterization of Long Distance Mismatch of CMOS Devices, Proceedings of the ICMTS 2000

[5] P.M. Ajayan, Nanotubes from Carbon, Chemical Review, S. 1787 - 1799, 1999

[6] Z.F. Ren et al, Synthesis of Large Arrays of Well-Aligned Carbon Nanotubes on Glass, Science, Vol. 282, S. 1105 - 1107, November 1998

[7] S. Frank et al., Science 280, S. 1744, 1998

[8] Jing Kong et al, Synthesis of individual single-walled carbon nanotubes on patterned silicon wafers, Letters to Nature, Vol. 395, S. 878 - 881, Oktober 1998

[9] DE 31 10 800 C2

[10] DE 43 07 578 C2

**Bezugszeichenliste**

101 Kohlenstoff-Nanoröhre
102 Kontaktfläche
103 Kontaktfläche
104 Substrat

200 Widerstandskaskade
201 Spannungsquelle
202 elektrischer Widerstand
203 Abgriff

300 Analog-/Digital-Wandler
301 Komparator
302 Erster Eingang Komparator
303 Analoges Eingangssignal
304 Eingang Analog-/Digital-Wandler
305 Eingangsleitung
306 Zweiter Eingang Komparator
307 Ausgang Komparator
308 Eingang Auswertelogik
309 Auswertelogik
310 Digitales Ausgangssignal
311 Ausgang Auswertelogik

**Patentansprüche**

1. Widerstandskaskade zum Bilden elektrischer Referenzgrößen,

   - mit einer Mehrzahl elektrischer Widerstände, die in Serie geschaltet sind,
   - wobei jeder elektrischer Widerstand mindestens eine Kohlenstoff-Nanoröhre aufweist.

2. Widerstandskaskade nach Anspruch 1, bei dem zumindest ein Teil der elektrischen Widerstände mehrere, parallel geschaltete Kohlenstoff-Nanoröhren aufweist.

3. Widerstandskaskade nach Anspruch 1 oder 2, bei dem zumindest ein Teil der elektrischen Widerstände mehrere, in Serie geschaltete Kohlenstoff-Nanoröhren aufweist.

4. Widerstandskaskade nach einem der Ansprüche 1 bis 3, mit einer Spannungsquelle, mit der eine Referenzspannung bereitgestellt wird, aus der gemäß der Struktur der Widerstandskaskade die Referenzgrößen bereitgestellt werden.

5. Analog-/Digital-Wandler

   - mit einer Widerstandskaskade nach einem der Ansprüche 1 bis 3,
   - mit einer der Anzahl elektrischer Widerstände entsprechenden Anzahl Komparatoren,
   - wobei jeweils ein Abgriff der Widerstandskaskade mit einem ersten Eingang einer der Komparatoren gekoppelt sind zum Bilden einer Referenzgröße an dem ersten Eingang des jeweiligen Komparators, und
   - wobei an einen zweiten Eingang jedes Komparators ein analoges Signal anlegbar ist.

6. Analog-/Digital-Wandler nach Anspruch 5, mit einer Auswertelogik, deren Eingänge mit den Ausgängen der Komparatoren gekoppelt sind zum Bilden eines oder mehrerer digitaler Ausgangssignale.

# FIG 1

# FIG 2

FIG 3

EP 1 182 784 A2